# EUROPEAN PATENT SPECIFICATION

(11) **EP 0 319 216 B1**
(45) Date of publication and mention of the grant of the patent: **27.07.1994**
(21) Application number: 88311224.5
(22) Date of filing: 25.11.1988
(51) Int. Cl.: H03M 5/18, G11B 20/14, G11B 20/10, H04L 25/49

(54) **Coding apparatus and magnetic recording system the same**
Kodierungsgerät und dieses Gerät verwendendes magnetisches Aufzeichnungssystem
Appareil de codage et système d'enregistrement magnétique utilisant cet appareil

(30) Priority: 01.12.1987 JP 305052/87; 19.02.1988 JP 38173/87
(43) Date of publication of application: 07.06.1989
(73) Proprietor: MATSUSHITA ELECTRIC INDUSTRIAL CO., LTD., Kadoma-shi, Osaka-fu, 571 (JP)
(72) Inventor: Kobayashi, Masaaki, Kawanishi-shi Hyogo-ken, 666-01 (JP); Nagaoka, Yoshitomi, Neyagawa-shi Osaka-fu, 572 (JP); Shimotashiro, Masafumi, Myoutoku Neyagawa-shi Osaka-fu, 572 (JP); Matsuda, Toyohiko, Neyagawa-shi Osaka-fu, 572 (JP)
(74) Representative: Crawford, Andrew Birkby

(56) References cited:
- IEEE TRANSACTIONS ON COMMUNICATIONS, vol. 35, no. 2, February 1987, New York, NY, US; D.Y. KIM et al.: "Run-length-limited variants of duobinary and modified duobinary"
- PATENT ABSTRACTS OF JAPAN, vol. 6, no. 115 (E-115)[993], 26th June 1982; & JP-A-57 42 249 (NIPPON DENSHIN DENWA KOSHA) 09-03-1982
- JOURNAL OF THE INSTITUTION OF ELECTRONIC AND RADIO ENGINEERS, vol. 56, no. 4, April 1986, pages 159-168, London, GB; F.C. COURT: "Minimum bandwidth dicode signalling"

## Description

This invention relates to a coding apparatus for coding digital signals and a magnetic recording system using the same.

As one type of code for coding digital signals, a correlative code is available. The system using this code transmits information of one time slot as a multi-value signal distributed to a plurality of time slots. Examples of this type include, for example, duobinary and partial response coding.

Because the information is received as a multi-valued signal, transmission is possible at a narrower frequency band as compared with systems in which reception is of a binary value (such as, for example, NRZ). In order to transmit information at a narrower frequency band using the correlative code, however, the number of multi-value levels increases unavoidably, so that there exists such a problem that the SN ratio of the transmission line is required to be improved. In addition, since the above-mentioned correlative code contains a DC component, when it is to be recorded using a magnetic recording system, there arises a problem that it is not suited for a recording code because an electromagnetic conversion system of the magnetic recording system has a difficulty to do DC transmission.

An object of this invention is to provide a coding apparatus for coding digital signals to ternary signals whose DC component becomes zero and yet their transmission is made possible at a narrow frequency band.

Another object of this invention is to provide a magnetic recording system using said coding apparatus.

According to the present invention, there is provided a coding apparatus comprising: duobinary signal generating means for converting an input two-valued signal string into a duobinary signal string; sign inverting means for selectively inverting the sign of said duobinary signal; and control means for controlling the operation of said sign inverting means so as to render zero the mean value of the duobinary signal string output by said inverting means, wherein said control means comprises code value storing means that is operable to store the preceding value of said duobinary signal string output each time this signal value changes to zero, detection means for providing a detection signal each time the said signal string output changes from zero, and coincidence detecting means that provide a control signal to the sign inverting means only when both i) the said stored value differs from zero and ii) the detection means provides said detection signal.

A magnetic recording system in accordance with this invention is structured such that an output signal of the above-mentioned sign inverting circuit is supplied through a recording amplifier to a recording head to be stored into a magnetic recording medium.

For the reason that the apparatus of this invention allows a signal to be obtained which is a ternary signal similar to the duobinary signal and yet its DC component becomes zero, the transmission can be carried out at a narrower frequency band than that when the duobinary signal is used. Thus, a coding apparatus in accordance with this invention may be easily introduced into a system such as, for example, a tape-head system of a video-tape recorder or a disk-head system of a floppy disk or hard disk drive, wherein it is difficult to transmit a direct current signal.

Fig. 1 is a block diagram showing a structure of a coding apparatus in accordance with an embodiment of this invention.

Figs. 2 (a) to (d) are signal waveform diagrams showing waveforms at representative points in Fig. 1, Fig. 3 and Fig. 4.

Fig. 3 is a block diagram showing an example of the duobinary signal generating circuit in Fig. 1.

Fig. 4 is a block diagram showing an example of each of the sign inverting circuit and sign inversion control signal generating circuit in Fig. 1.

Fig. 5 is a block diagram showing a structure of a magnetic recording system in accordance with an embodiment of this invention.

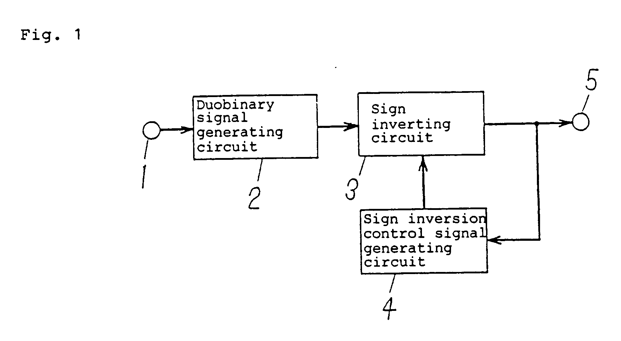

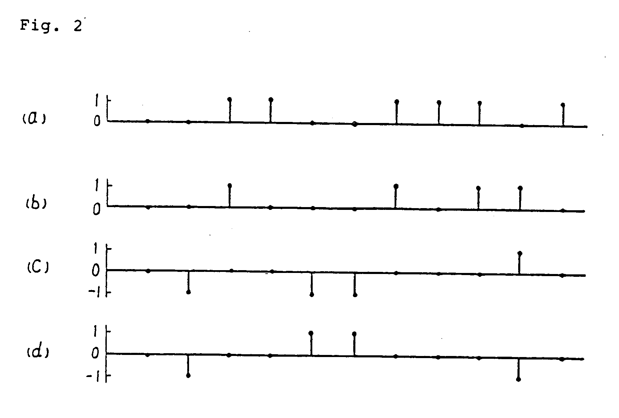

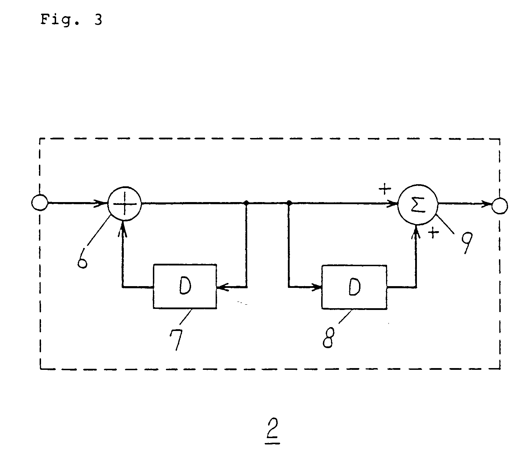

Fig. 1 shows a block diagram of a coding apparatus of an embodiment of this invention. Figs. 2 (a) to (d) show signal waveforms for explaining the apparatus shown in Fig. 1. Fig. 2 (a) shows a waveform of a signal inputted into an input terminal 1. This input signal is supplied to a duobinary signal generating circuit 2. The duobinary signal generating circuit 2 is well known and consists, for example, as shown in Fig. 3, of a modulo-two adder 6, delay circuits 7 and 8, and an algebratic summing circuit 9. In addition, the modulo-two adder 6 and the delay circuit 7 constitutes a precoder. The output signal thereof (an output signal of the module-two adder 6) is shown in Fig. 2 (b). The operation of the duobinary signal generating circuit 2 is described, for example, in Sanpo-Shuppan's "Technology of PCM Communications" (by Hisashi Kaneko), p. 79 or "IEEE Transactions on Communication Technology," FEB., 1966, pp. 67 - 68. Fig. 2 (c) shows a waveform of an output signal of said duobinary signal generating circuit 2. This is the generally called duobinary signal. This signal generally has a direct current component, and in such cases as, for example, a string of '0' → '1' → '0' → '1', a value of '1' appears again subsequently to '1' and a value other than zero will result. Another case such as, for example, a string of '0'→ '-1' → '0' →'-1', a value of '-1' appears again subsequently to '-1' and a value other than zero will result. These are the reasons that it has a direct current component. In the electromagnetic converting system of a magnetic recording and reproducing apparatus whose code transmission line is made of a tape-head and the like, if a signal has a direct current component, then the waveform of a signal to be reproduced will cause an increased distortion, resulting in an increase of the probability of code errors. As explained below, the sign inverting circuit 3 and the sign inversion control signal generating circuit 4 of the coding apparatus of this invention is structured such that when a value of '0' appears following a string of '0' → '1' (or in the case that '1' appears continuously, if it appears following the completion of successive '1's) and then a value of '-1' appears successively thereto (in the case that '0' appears successively, if it appears following the completion of the successive '0's), the input value is outputted as it is, and if a value of '1' appears instead of '-1', the input value is outputted after it has been sign-inverted to '-1'.

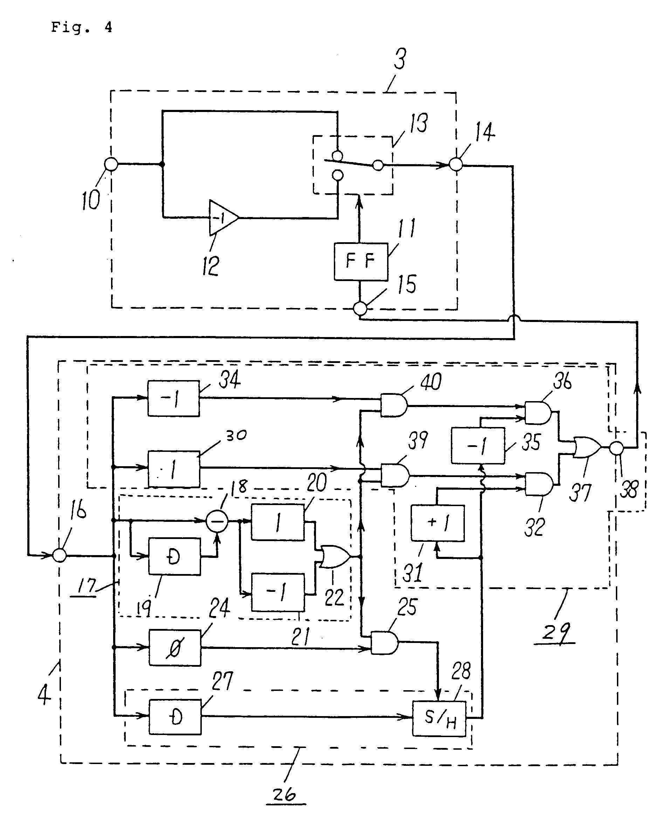

Concrete examples of the sign inverting circuit 3 and sign inversion control signal generating circuit 4 in Fig. 1 are shown in Fig. 4. In Fig. 4, the sign inverting circuit 3 comprises an input terminal 10 for inputting a duobinary signal, a switch 13, a polarity inverting circuit 12, a flip-flop circuit 11, an output terminal 14 and an input terminal 15 for inputting an inversion pulse. The sign inversion control signal generating circuit 4 comprises an input terminal 16 which is to be connected to the above-mentioned output terminal 14, a preceding value comparator 17 for discriminating a change of a present value from the preceding one, a zero detection circuit 24 for detecting that the present value is zero, an AND circuit 25 for obtaining a logical product of the output of the preceding value comparator 17 and the output of the zero detection circuit 24, a memory circuit 26 for storing the preceding value when the present value is changed from the preceding value and further the present value is '0', a coincidence detecting circuit 29 for detecting that the present value of an input signal is a value other than '0' and further it is coincident with the output signal of the memory circuit 26, and an output terminal 38 for outputting an inversion pulse (p). The preceding value comparator 17 comprises, for example, a subtracter 18, a delay circuit 19, a '1' detecting circuit 20, a '-1' detecting circuit 21, and an OR circuit 22. The memory circuit 26 comprises a delay circuit 27 and a sample-hold circuit 28. The coincidence detecting circuit 29 comprises '-1' detecting circuits 34 and 35, '1' detecting circuits 30 and 31, AND circuits 32, 36, 39 and 40, and an OR circuit 37. In addition, each of the delay circuits 19 and 27 is made, for example, of a D flip-flop and delays an input signal string by one time-slot. The '1' detecting circuits 20, 30 and 31 are each a well-known level comparator. The '-1' detecting circuits 21, 34, 35 and the '0' detecting circuit 24 are each a well-known level comparator.

Through the sign inverting circuit 3 and the sign inversion control signal generating circuit 4 structured as above, the duobinary signal supplied to the input terminal 14 is subjected to transformation thereby to be such an output signal string as shown in Fig. 2 (d). The output signal string shown Fig. 2 (d) is outputted in conformity with the above-mentioned rule, that is, when a value of '0' appears following s string of '0' →'1' (in the case that '1' appears continuously, if it appears following the completion of successive '1's) and then a value of '-1' appears successively thereto (in the case that '0' appears continuously, if it appears following the completion of successive '0's), the input value is outputted as it is, and if a value of '1' appears instead of '-1', the input value is outputted after it has been sign-inverted to '-1'. Based on the same rule as above, when a value of '0' appears following a string of '0' →'-1' and then '1' appears successively thereto, the input value is outputted as it is, and if a value of '-1' appears instead of '1', the input value is outputted after it has been sign-inverted to '1'. Therefore, the DC component thereof becomes approximately zero when considered in terms of the mean value over time.

Also, a coding apparatus of this invention is not limited to the apparatus shown in Fig. 1, and the duobinary signal can be changed in waveform in such a way that when a value of '0' appears following '1' (in the case that '1' appears continuously, if it appears following the completion of successive '1's) and then a value of '-1' appears successively thereto (in the case that '0' appears continuously, if it appears following the completion of successive '0's), the input value is outputted as it is, and if a value of '1' appears instead of '-1', the input value is outputted after it has been sign-inverted to '-1'. Similarly, when a value of '0' appears following '-1' (or in the case that '-1' appears continuously, it appears following the completion of successive '-1's) and then a value of '1' appears successively thereto (or in the case that '0' appears continuously, it appears following the completion of successive '0's), the input value is outputted as it is, and if a value of '-1' appears instead of '1', the input value is outputted after it has been sign-inverted to '1'.

For example, another embodiment of a coding apparatus of this invention is that in Fig. 1, wherein an output signal of the duobinary signal generating circuit 2 is input to the sign inversion control signal generating circuit 4, and the sign inverting circuit 3 is controlled by the output signal of the sign inversion control signal generating circuit 4 thereby transforming the duobinary signal in accordance with the above-mentioned rule.

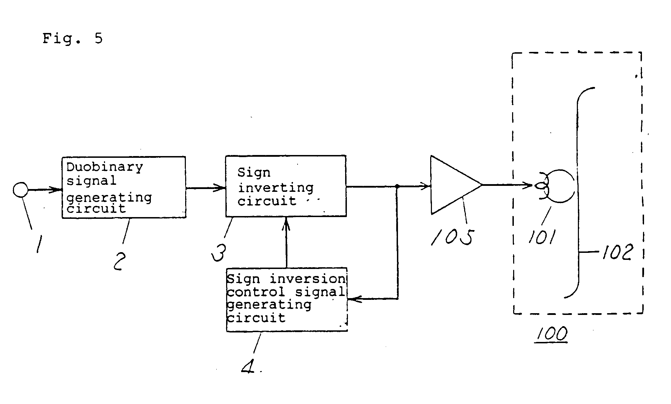

A magnetic recording system of this invention is structured such that a signal string obtained as shown above is supplied through a recording amplifier 105 to a tape-head system 100 as shown in Fig. 5. The tape-head system 100 comprises a magnetic head 101 and a magnetic tape 102. Concretely, the tape-head system 100 can be of a type such as, for example, helical scanning to be used in home VTR. In addition, other magnetic recording media such as, for example, magnetic disk can be used instead of the magnetic tape 102 for the recording purpose.

## Claims

1. A coding apparatus comprising: duobinary signal generating means for converting an input two-valued signal string into a duobinary signal string; sign inverting means (3) for selectively inverting the sign of said duobinary signal; and control means (4) for controlling the operation of said sign inverting means so as to render zero the mean value of the duobinary signal string output by said inverting means (3), wherein said control means (4) comprises code value storing means (26) that is operable to store the preceding value of said duobinary signal string output each time this signal value changes to zero, detection means (30,34,39,40) for providing a detection signal each time the said signal string output changes from zero, and coincidence detecting means (31,32,35,36,37) that provide a control signal to the sign inverting means (3) only when both i) the said stored value differs from zero and ii) the detection means (30, 34, 39, 40) provides said detection signal.

2. A magnetic recording system comprising:
a coding apparatus according to claim 1; and
recording means (100) for recording the output of said sign inverting means (3) onto a magnetic recording medium (102).

## Patentansprüche

1. Kodiervorrichtung, die umfaßt: eine Einrichtung zum Erzeugen eines duobinären Signals, die eine Folge zweiwertiger Eingangssignale in eine duobinäre Signalfolge umwandelt; eine Vorzeichenumkehreinrichtung (3), die wahlweise das Vorzeichen des duobinären Signals umkehrt; sowie eine Steuereinrichtung (4), die die Funktion der Vorzeichenumkehreinrichtung steuert, um den Mittelwert der von der Umkehreinrichtung (3) ausgegebenen duobinären Signalfolge auf Null zu bringen, wobei die Steuereinrichtung (4) eine Codewert-Speichereinrichtung (26) umfaßt, die den vorhergehenden Wert des duobinären Signalfolgeausgangs jedes Mal speichert, wenn sich dieser Signalwert auf Null ändert, eine Erfassungseinrichtung (30,34,39,40), die jedes Mal ein Erfassungssignal erzeugt, wenn sich der Signalfolgeausgang von Null ändert, sowie Koinzidenzerfassungseinrichtungen (31,32,35,36,37), die nur dann ein Steuersignal für die Vorzeichenumkehreinrichtung (3) erzeugen, wenn sowohl i) der gespeicherte Wert von Null verschieden ist, als auch ii) die Erfassungseinrichtung (30,34,39,40) das Erfassungssignal erzeugt.

2. Magnetaufzeichnungssystem, das umfaßt:
eine Kodiervorrichtung nach Anspruch 1; und
eine Aufzeichnungseinrichtung (100) zur Aufzeichnung des Ausgangs der Vorzeichenumkehreinrichtung (3) auf ein magnetisches Aufzeichnungsmedium (102).

## Revendications

1. Dispositif de codage comprenant : un moyen générateur de signaux duobinaires pour convertir une suite de signaux d'entrée à deux valeurs en une suite de signaux duobinaires ; un moyen d'inversion de signe (3) pour inverser de manière sélective le signe dudit signal duobinaire ; et un moyen de commande (4) pour commander le fonctionnement dudit moyen d'inversion de signe de manière à rendre nulle la valeur moyenne de la suite de signaux duobinaires sortie par ledit moyen d'inversion (3), dans lequel ledit moyen de commande (4) comprend un moyen de mémorisation de valeur de codage (26) qui sert à mémoriser la valeur précédente de ladite suite de signaux duobinaires sortie chaque fois que cette valeur de signal devient zéro, un moyen de détection (30, 34, 39, 40) pour fournir un signal de détection chaque fois que ladite suite de signaux sortie varie à partir de la valeur zéro, et un moyen de détection de coïncidence (31, 32, 35, 36, 37) qui délivre un signal de commande au moyen d'inversion de signe (3) seulement si, à la fois, i) ladite valeur mémorisée diffère de zéro, et ii) le moyen de détection (30, 34, 39, 40) délivre ledit signal de détection.

2. Système d'enregistrement magnétique comprenant :
un dispositif de codage selon la revendication 1 ; et
un moyen d'enregistrement (100) pour enregistrer la sortie dudit moyen d'inversion de signe (3) sur un support d'enregistrement magnétique (102).
